(19) Europäisches Patentamt
European Patent Office
Office européen des brevets

(11) **EP 4 768 952 A1**

(12) **EUROPEAN PATENT APPLICATION**
published in accordance with Art. 153(4) EPC

(43) Date of publication:
**01.07.2026 Bulletin 2026/27**

(21) Application number: **25833364.0**

(22) Date of filing: **29.05.2025**

(51) International Patent Classification (IPC):
*G01R 31/385* (2019.01)       *G01R 31/389* (2019.01)
*G01R 31/396* (2019.01)       *G01R 31/371* (2019.01)
*G01R 31/374* (2019.01)       *G01R 31/367* (2019.01)
*G01R 27/08* (2006.01)       *H02J 7/00* (2026.01)

(52) Cooperative Patent Classification (CPC):
**G01R 27/08; G01R 31/367; G01R 31/371;
G01R 31/374; G01R 31/385; G01R 31/389;
G01R 31/396; H02J 7/00;** Y02E 60/10

(86) International application number:
**PCT/KR2025/007346**

(87) International publication number:
**WO 2026/010167 (08.01.2026 Gazette 2026/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **01.07.2024 KR 20240086062**

(71) Applicant: **LG Energy Solution, Ltd.
Seoul 07335 (KR)**

(72) Inventors:
• **YANG, Sun Woo
  Daejeon 34122 (KR)**
• **KIM, Dae Hong
  Daejeon 34122 (KR)**
• **LEE, Dong Hun
  Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY INSPECTION SYSTEM AND BATTERY INSPECTION METHOD**

(57)     According to some embodiments, a battery inspection system includes a charging/discharging device configured to perform charging/discharging on a target battery in a capacity measurement process and a control device configured to calculate a battery capacity of the target battery based on charging/discharging data in the capacity measurement process, calculate a first internal resistance of the target battery based on the charging/discharging data in at least a partial section of a charging/discharging section of the capacity measurement process, and correct the first internal resistance to a second internal resistance based on a difference between a first battery environment in the capacity measurement process and a second battery environment for battery shipment.

FIG.2

**Description**

**TECHNICAL FIELD**

**Cross-reference to Related Applications**

This application claims priority from Korean Patent Application No. 10-2024-0086062, filed on July 1, 2024, the disclosure of which is incorporated by reference herein.

**Technical Field**

Embodiments disclosed in this document relate to a battery inspection system and a battery inspection method.

**BACKGROUND ART**

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Among secondary batteries, lithium-ion batteries can have higher energy density than conventional Ni/Cd batteries, Ni/MH batteries, etc., and may be manufactured in a small and lightweight form, and thus may have high utilization as a power source for mobile devices. Recently, the scope of use of the lithium ion batteries has expanded to include a power source for electric vehicles, and the lithium ion batteries are attracting attention as a next-generation energy storage medium.

In order to complete the manufacturing of battery cells and ship the battery cell, a process of charging the battery cell with a shipment SOC and an end of line (EOL) process may be performed. A capacity and internal resistance of an assembled cell may be inspected before the assembled cell enters the EOL process. Since the battery capacity involves discharging cells to a completely discharged state, in conventional inspection techniques, cells that have been subjected to capacity inspection are partially charged to the shipping SOC and then a separate charge/discharge operation for inspecting the internal resistance is performed. Such a conventional method may be problematic in that it is inefficient in terms of an increase in the number of charging and discharging times, a complicated transfer path, etc.

**DISCLOSURE OF THE INVENTION**

**TECHNICAL PROBLEM**

Embodiments disclosed in this document provide a battery inspection system and a battery inspection method that can eliminate inefficiency due to additional charging/discharging operations for internal resistance measurement.

The technical problems of this document are not limited to the technical problems mentioned above, and other technical problems that are not mentioned may be clearly understood by those skilled in the art from the descriptions below.

**TECHNICAL SOLUTION**

According to some embodiments, a battery inspection system includes a charging/discharging device configured to perform charging/discharging on a target battery in a capacity measurement process and a control device configured to calculate a battery capacity of the target battery based on charging/discharging data in the capacity measurement process, calculate a first internal resistance of the target battery based on the charging/discharging data in at least a partial section of a charging/discharging section of the capacity measurement process, and correct the first internal resistance to a second internal resistance based on a difference between a first battery environment of the capacity measurement process and a second battery environment for battery shipment.

According to some embodiments, the charging/discharging device is configured to partially charge the target battery according to a shipping condition in a shipment charging process when the charging/discharging section of the capacity measurement process is completed.

According to some embodiments, the battery inspection system further includes a transfer device configured to transfer the target battery from the shipment charging process to an end of line (EOL) process when the partial charging of the target battery is completed in the shipment charging process, and the second battery environment represents an environment in which an internal resistance measurement process does not exist between the shipment charging process and the EOL process.

According to some embodiments, the charging/discharging section of the capacity measurement process includes a first section for discharging the target battery from a full charging state to a full discharging state, and the control device is configured to calculate the first internal resistance based on the charging/discharging data in a second section of at least a part of the first section.

According to some embodiments, a start point in time of the first section coincides with a start point in time of the second section, and the control device is configured to calculate the first internal resistance based on a discharging current value in the first section set for measuring the battery capacity in the capacity measurement process and a voltage decrease amount of the target battery during the second section.

According to some embodiments, the difference between the first battery environment and the second battery environment includes a difference between a first SOC value corresponding to a full charging state of the second section and a second SOC value corresponding to a partial charging state for the battery shipment, and the control device is configured to correct the first internal resistance to the second internal resistance based on the difference between the first SOC value and the second SOC value.

According to some embodiments, the difference between the first battery environment and the second battery environment includes a difference between a first battery temperature in the capacity measurement process and a second battery temperature in the shipment charging process, and the control device is configured to correct the first internal resistance to the second internal resistance based on the difference between the first battery temperature and the second battery temperature.

According to some embodiments, a battery inspection method includes performing charging/discharging on a target battery in a capacity measurement process, calculating a battery capacity of the target battery based on charging/discharging data in the capacity measurement process, calculating a first internal resistance of the target battery based on the charging/discharging data in at least a partial section of a charging/discharging section of the capacity measurement process, and correcting the first internal resistance to a second internal resistance based on a difference between a first battery environment in the capacity measurement process and a second battery environment for battery shipment.

According to some embodiments, the battery inspection method further includes partially charging the target battery according to a shipping condition in a shipment charging process when the charging/discharging section of the capacity measurement process is completed.

According to some embodiments, the battery inspection method further includes transferring the target battery from the shipment charging process to an end of line (EOL) process when the partial charging of the target battery is completed in the shipment charging process, and the second battery environment represents an environment in which an internal resistance measurement process does not exist between the shipment charging process and the EOL process.

According to some embodiments, the charging/discharging section of the capacity measurement process includes a first section for discharging the target battery from a full charging state to a full discharging state, and the calculating of the first internal resistance includes calculating the first internal resistance based on the charging/discharging data in a second section of at least a part of the first section.

According to some embodiments, a start point in time of the first section coincides with a start point in time of the second section, and the calculating of the first internal resistance includes calculating the first internal resistance based on a discharging current value in the first section set for measuring the battery capacity in the capacity measurement process and a voltage decrease amount of the target battery during the second section.

According to some embodiments, the difference between the first battery environment and the second battery environment includes a difference between a first SOC value corresponding to a full charging state of the second section and a second SOC value corresponding to a partial charging state for the battery shipment, and the correcting of the first internal resistance to the second internal resistance includes correcting the first internal resistance to the second internal resistance based on the difference between the first SOC value and the second SOC value.

According to some embodiments, the difference between the first battery environment and the second battery environment includes a difference between a first battery temperature in the capacity measurement process and a second battery temperature in the shipment charging process, and the correcting of the first internal resistance to the second internal resistance includes correcting the first internal resistance to the second internal resistance based on the difference between the first battery temperature and the second battery temperature.

## ADVANTAGEOUS EFFECTS

According to the embodiments disclosed in this document, a battery inspection system and a battery inspection method that can eliminate inefficiency caused by additional charging/discharging operations for internal resistance measurement can be provided.

The technical effects according to the embodiments disclosed in this document are not limited to the effects mentioned above, and other effects not mentioned will be clearly understood by those skilled in the art according to the disclosure of this document.

## BRIEF DESCRIPTION OF THE DRAWINGS

FIG. 1 illustrates a battery inspection system for inspecting a target battery according to some embodiments.
FIG. 2 illustrates components constituting a battery inspection system according to some embodiments.
FIG. 3 illustrates a conventional inspection method having a separate charging/discharging process for measuring internal resistance.
FIG. 4 illustrates a method of measuring an internal resistance without a separate charging/discharging process by a battery inspection system according to some embodiments.
FIG. 5 and FIG. 6 illustrate a method of calculating an internal resistance based on a voltage decrease amount measured in a second section of a capacity measurement process according to some embodiments.
FIG. 7 illustrates a method of correcting a first internal resistance to a second internal resistance based on differences in battery environments according to some embodiments.
FIG. 8 illustrates a method of correcting an internal resistance of a battery based on a relationship between a temperature and a resistance according to some embodiments.
FIG. 9 illustrates a method of correcting a battery internal resistance based on a difference in battery SOC according to some embodiments.
FIGS. 10 and 11 illustrate a difference between a battery inspection system and a conventional inspection method according to some embodiments.
FIG. 12 illustrates steps that constitute a battery inspection method according to some embodiments.

## MODE FOR CARRYING OUT THE INVENTION

Hereinafter, embodiments of the present invention will be described with reference to the accompanying drawings. However, this is not intended to limit the present invention to a specific embodiment, but should be understood to include various modifications, equivalents, and/or alternatives of the embodiments of the present invention.

It should be understood that embodiments of this document and the terminology used therein are not intended to limit the technical features described in this document to specific embodiments, but rather to encompass various modifications, equivalents, or alternatives of the embodiments. In connection with the description of the drawings, similar reference numerals may be used for similar or related components. The singular form of a noun corresponding to an item may include one or more of said item, unless the relevant context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase among the phrases, or all possible combinations thereof. Terms such as "first", "second", or "firstly" or "secondly" may be used merely to distinguish one component from another, and, unless otherwise specifically stated, do not limit the components in any other respect (e.g., importance or order). Terms such as "first", "second", or "firstly" or "secondly", "A", "B", "(a)" or "(b)" may be used merely to distinguish one component from another, and, unless otherwise specifically stated, do not limit the components in any other respect (e.g., importance or order).

In this document, when a component (e.g., a first component) is referred to as being "coupled", "connected", or "joined" to another component (e.g., a second component), with or without the terms "functionally" or "communicatively", it means that the component can be connected to the other component directly (e.g., in a wired manner or wirelessly) or indirectly (e.g., through a third component).

The method according to various embodiments disclosed in this document may be provided by being included in a computer program product. The computer program product may be traded between a seller and a buyer as a product. The computer program product may be distributed in the form of a machine-readable storage medium (e.g., a compact disc read only memory (CD-ROM)), or may be distributed online (e.g., downloaded or uploaded) through an application store or directly between two user devices. In the case of online distribution, at least a part of a computer program product may be temporarily stored or temporarily generated in a machine-readable storage medium such as a memory of a manufacturer's server, an application store's server, a relay server.

According to the embodiments disclosed in this document, each component (e.g., a module or a program) of the components described above may include a single or a plurality of entities, and some of the plurality of entities may be separated and placed in other components. According to the embodiments disclosed in this document, one or more of the components described above among the components or operations may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to the embodiments disclosed in this document, the operations performed by a module, program, or other component may be performed sequentially, in parallel, repeatedly, or heuristically, or one or more of the operations may be performed in a different order, omitted, or performed by adding one or more other operations.

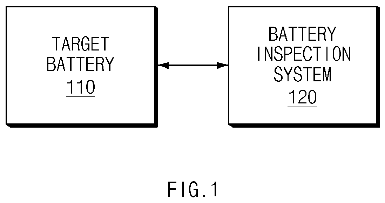

FIG. 1 illustrates a battery inspection system for inspecting a target battery according to some embodiments.

Referring to FIG. 1, a battery inspection system 120 may be configured to inspect a target battery 110.

The target battery 110 may include a battery cell manufactured through a battery manufacturing process. For example, the target battery 110 may be formed by completion of a formation process, and the capacity and internal resistance of the target battery 110 may be inspected. When the inspection of the target battery 110 is completed, the target battery 110 may be charged to a shipment SOC, and an EOL process for the target battery 110 may be performed.

The battery inspection system 120 may inspect the capacity, internal resistance, etc. of the target battery 110, and when the inspection is completed, the target battery 110 may be transferred to another process, such as a shipment charging process or an EOL process. The battery inspection system 120 may perform charging and/or discharging on the target battery 110 in the process of inspecting the capacity, internal resistance, etc. If the inspection result indicates that the capacity and/or internal resistance is defective, the battery inspection system 120 may recover the target battery 110 for re-inspection and/or disposal. If the capacity and/or internal resistance is normal, the target battery 110 may subsequently proceed to the shipment process.

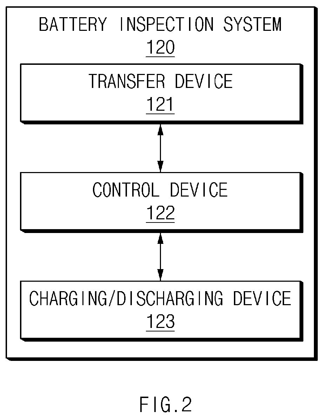

FIG. 2 illustrates components constituting a battery inspection system according to some embodiments.

Referring to FIG. 2, the battery inspection system 120 may include a transfer device 121, a control device 122, and a charging/discharging device 123. However, it is not limited thereto, and some components may be omitted from the battery inspection system 120, or other general-purpose components may be further included in the battery inspection system 120.

The transfer device 121 may transfer the target battery 110 during the battery manufacturing process. For example, the transfer device 121 may transfer the target battery 110 for the formation process, the capacity measurement process, the shipment charging process, the EOL process, etc. The transfer device 121 may include a transfer means such as a conveyor belt for transferring the target battery 110.

The control device 122 may perform inspection operations on the target battery 110. For example, the control device 122 may inspect the capacity, internal resistance, etc. of the target battery 110. The control device 122 may control operations of other components of the battery inspection system 120. For example, the control device 122 may control the operation of the transfer device 121 and/or the operation of the charging/discharging device 123, etc.

The control device 122 may include a memory and/or a processor. The processor may be implemented in the form of at least one of a logic gate array, a microprocessor, a CPU, a GPU, and an AP. The memory may be implemented in the form of a nonvolatile device such as a ROM, a PROM, an EPROM, an EEPROM, a flash memory, a PRAM, a MRAM, a RRAM, a FRAM, etc., or a volatile device such as a DRAM, a SRAM, a SDRAM, a PRAM, etc., and may be implemented in the form of a HDD, an SSD, an SD, a Micro-SD, etc., or a combination thereof.

The charging/discharging device 123 may perform charging and/or discharging of the target battery 110. For example, the charging/discharging device 123 may charge or discharge the target battery 110 in the process of measuring the capacity and/or internal resistance of the target battery 110. For example, the charging/discharging device 123 may include a charging/discharging means such as a DC power supply.

The charging/discharging device 123 may be configured to perform charging/discharging of the target battery 110 in the capacity measurement process. The control device 122 may be configured to calculate the battery capacity of the target battery 110 based on charging/discharging data of the target battery 110 due to the charging/discharging in the capacity measurement process. For example, the charging/discharging device 123 may charge the target battery 110 to a full charging state and then discharge the target battery 110 to a full discharging state in the capacity measurement process, and the battery capacity may be calculated based on the battery data during the process. For example, the battery capacity may be calculated based on a SOC value in the full charging state and a SOC value in the full discharging state.

The control device 122 may be configured to calculate a first internal resistance of the target battery 110 based on the charging/discharging data in at least a partial section of the charging/discharging section of the capacity measurement process. In the conventional battery inspection process, the process for inspecting the internal resistance exists separately from the capacity measurement process, but in the battery inspection system 120, both the capacity and internal resistance of the target battery 110 may be calculated in the capacity measurement process. The first internal resistance of the target battery 110 may be calculated based on the data in a part of the charging/discharging section of the capacity measurement process. For example, the first internal resistance may be calculated based on data in a discharging section of the charging/discharging section.

The control device 122 may be configured to correct the first internal resistance to a second internal resistance based on a difference between a first battery environment of the capacity measurement process and a second battery environment for battery shipment. The first battery environment of the capacity measurement process may be different from a battery shipment environment in terms of the temperature, SOC, etc. of the target battery 110. Since an inspection criterion value that the internal resistance value of the target battery 110 should satisfy is set based on the battery shipment environment, it may be necessary to correct this when measuring the internal resistance value based on the first battery environment of the capacity measurement process.

The transfer device 121 may be configured to transfer the target battery 110 from the capacity measurement process to the shipment charging process for partially charging the target battery 110 when the measurement of the battery capacity and the second internal resistance is completed. Unlike the conventional battery inspection process in which internal resistance measurement is performed after shipment charging, in the battery inspection system 120, the shipment charging process may be performed after both capacity and internal resistance are measured.

According to the embodiment, the charging/discharging device 123 may be configured to partially charge the target battery 110 according to the shipping condition in the shipment charging process when the charging/discharging section of the capacity measurement process is completed. For example, the shipment condition may include a shipment SOC condition, and the shipment SOC condition may be SOC 30% or less. The charging/discharging device 123 may partially charge the target battery 110 so that the SOC of the target battery 110 satisfies the shipment SOC condition.

According to an embodiment, the transfer device 121 may be configured to transfer the target battery 110 from the shipment charging process to the end of line (EOL) process when the partial charging of the target battery 110 is completed in the shipment charging process, and the second battery environment may represent an environment in which an internal resistance measurement process does not exist between the shipment charging process and the EOL process. Unlike the conventional battery inspection process where a separate internal resistance measurement process exists before the EOL process is performed, in the battery inspection system 120, since the internal resistance is already measured before the shipment charging is performed, the target battery 110 may be transferred to the EOL process immediately when the shipment charging is completed. This may reduce the number of operations of the charging/discharging device 123 and simplify a transfer path of the transfer device 121.

According to the embodiment, the charging/discharging section of the capacity measurement process may include a first section for discharging the target battery 110 from a full charging state to a full discharging state, and the control device 122 may be configured to calculate the first internal resistance based on the charging/discharging data in the second section of at least the part of the first section. For example, the first section may represent a discharging section in the capacity measurement process. The second section may be a section having a set duration, such as 10 seconds, and a numerical value of the duration may be changed in consideration of a calculation accuracy of the first internal resistance. Alternately, the duration of the second section may be 5%, 10%, 15%, 20%, 25%, 30%, 50%, etc. of the duration of the first section.

According to the embodiment, a start point in time of the first section may coincide with a start point in time of the second section, and the control device 122 may be configured to calculate the first internal resistance based on a discharging current value in the first section set to measure the battery capacity in the capacity measurement process and a voltage decrease amount of the target battery 110 during the second section. The first section and the second section may start at the same time, and the second section may end before the first section. Since the second section is a discharging section, the SOC and voltage of the target battery 110 may decrease during the second section. The voltage decrease amount in the second section may be a difference between the voltage at the start point in time and the voltage at the end point in time. Discharging in the first section may be performed by a constant current value. The charging/discharging device 123 may form a discharging current of a constant value in the target battery 110, thereby allowing the discharge to be performed during the first section. The first internal resistance may be calculated based on the discharging current value and the voltage decrease amount.

According to the embodiment, the difference between the first battery environment and the second battery environment may include a difference between a first SOC value corresponding to the full charging state of the second section and a second SOC value corresponding to the partial charging state for battery shipment, and the control device 122 may be configured to correct the first internal resistance to the second internal resistance based on the difference between the first SOC value and the second SOC value. If the SOC value in the battery cell changes, the value of the internal resistance may also change. Accordingly, even if the internal resistance test is passed in the capacity measurement environment, there may be cases where the internal resistance test is not passed in the battery shipment environment. In order to correct such an error, the internal resistance value may be corrected based on the difference between the first SOC value and the second SOC value. For example, the correction may be performed using a table, profile, etc. in which the mapping relationship between the SOC and the internal resistance is recorded. For example, the environment for calculating the first internal resistance may be SOC of approximately 95% or more and voltage of approximately 4 V or more, while the battery shipment environment may be SOC of approximately 30% to 80%, and the first internal resistance may be corrected to the second internal resistance in consideration of the this SOC difference.

According to the embodiment, the difference between the first battery environment and the second battery environment may include a difference between the first battery temperature in the capacity measurement process and the second battery temperature in the shipment charging process, and the control device 122 may be configured to correct the first internal resistance to the second internal resistance based on the difference between the first battery temperature and the second battery temperature. Similar to the SOC difference described above, the temperature difference may also cause fluctuations in internal resistance values. In consideration of this, additional correction may be performed to inspect the internal resistance value based on the temperature in the battery shipment environment. For example, the battery temperature just before the shipment charging process is completed and the battery is transferred to the EOL process may be an inspection criterion. In the battery inspection system 120, since both the capacity and the internal resistance may be measured in the capacity charging process and an internal resistance measurement process does not exist, the process of being transferred to the charging/discharging device 123 for internal resistance measurement through the transfer device 121 may be omitted, and the amount of battery temperature fluctuation during the transfer process may be reduced. In consideration of this difference, the difference between the first battery temperature and the second battery temperature may be calculated.

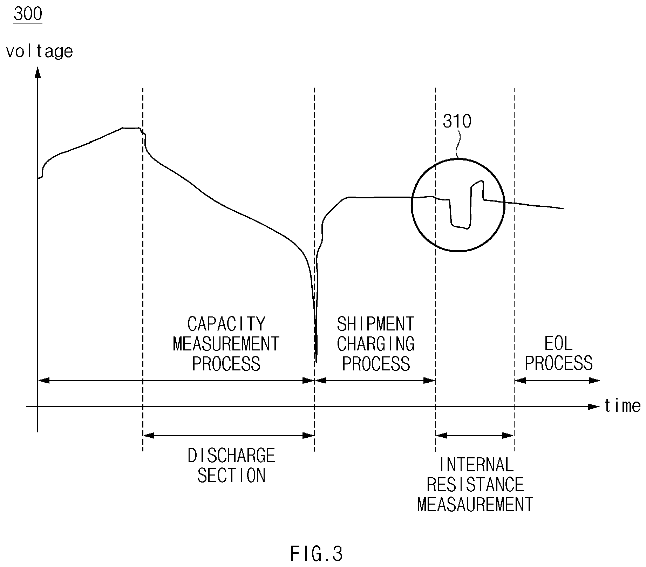

FIG. 3 illustrates a conventional inspection method having a separate charging and discharging process for measuring an internal resistance.

Referring to FIG. 3, a graph 300 illustrating a conventional inspection method having the separate charging and discharging process for measuring the internal resistance may be illustrated. The horizontal and vertical axes of the graph 300 may represent time and voltage.

In the graph 300, a formation process may be completed before the capacity measurement process begins. Battery charging may be performed in an early part of the capacity measurement process, and battery discharging may be performed in a discharging section in a latter part of the capacity measurement process.

When the discharging section is completed, the shipment charging process may be started. After being charged to the shipment SOC through the shipment charging, a separate charging/discharging 310 for measuring the internal resistance may be performed. Additional transfer to the charging/discharging device may be required for the charging/-discharging 310. When the internal resistance measurement is completed through the charging/discharging 310, the EOL process may be started.

In the conventional inspection method, capacity measurement and shipment charging may be performed in a first charger/discharger, and then internal resistance measurement may be performed in a second charger/discharger. Here, the first charger/discharger may be a general charger/discharger, and the second charger/discharger may be a large-capacity charger. Since it is difficult to measure the temperature in the second charger/discharger, the internal resistance may be calculated using the temperature at the point in time when shipment charging is completed in the first charger/discharger. Since the second charger/discharger is installed separately from the first charger/discharger, if the temperatures of the first and second chargers/dischargers are not the same, an error may occur in a calculation result of the internal resistance, and the conventional inspection method did not consider the correction of such an error.

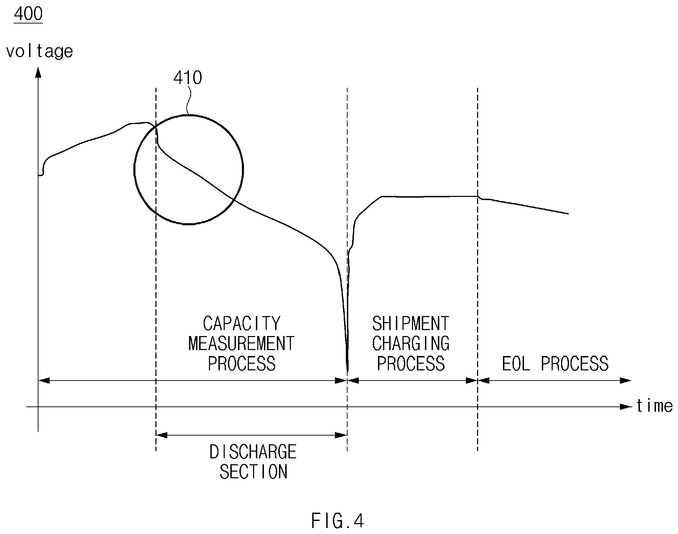

FIG. 4 illustrates a method of measuring internal resistance without a separate charging/discharging process by the battery inspection system 120 according to some embodiments.

Referring to FIG. 4, a graph 400 illustrating a method of measuring the internal resistance without the separate charging/discharging process by the battery inspection system 120 may be illustrated. The horizontal and vertical axes of the graph 400 may represent indicate time and voltage.

Unlike the graph 300 representing the conventional technology, in the graph 400, separate charging/discharging for measuring the internal resistance may not be performed before and after the shipment charging process. Instead, the internal resistance may be measured based on the charging/discharging data measured in an early part 410 of the discharging section. The first internal resistance measured in the early part 410 may be corrected to the second internal resistance by reflecting the battery shipping environment. In this way, the battery inspection system 120 may reduce the number of times of battery charging/discharging and simplify a battery transfer path compared to the conventional inspection method.

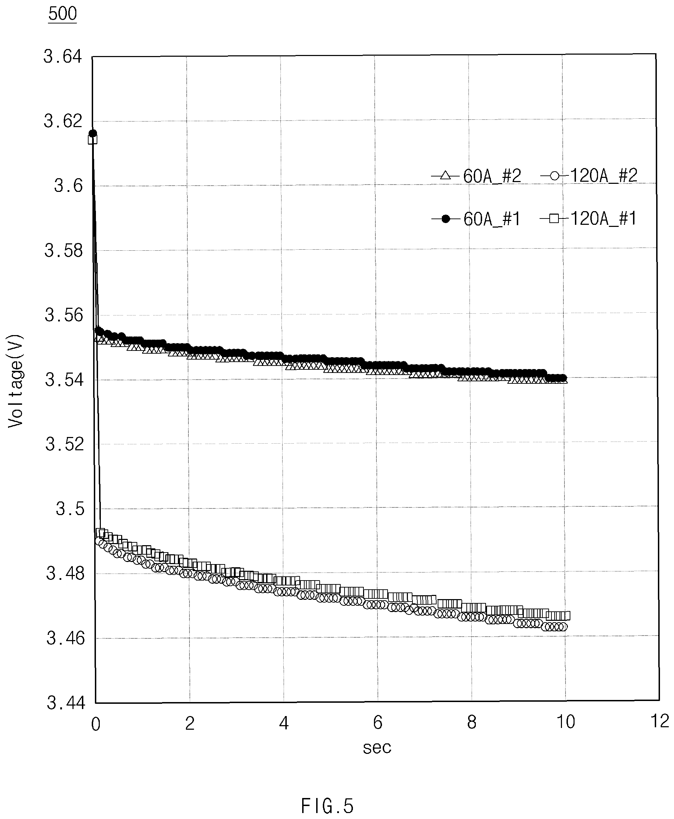

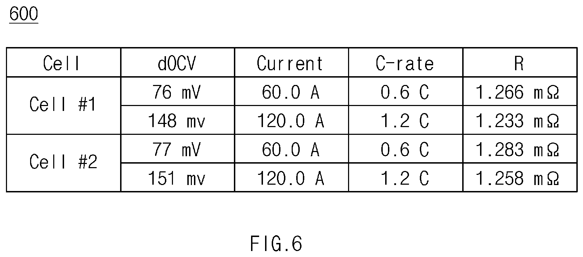

FIGS. 5 and 6 illustrate a method of calculating an internal resistance based on a voltage decrease amount measured in the second section of the capacity measurement process according to some embodiments.

Referring to FIG. 5, a graph 500 representing an open circuit voltage (OCV) measured in the second section corresponding to the early part of the discharging section of the capacity measurement process may be illustrated.

The graph 500 may represent cases where cell #1 and cell #2 are discharged at 60 A and 120 A in an early part of the discharging section of the capacity measurement process. The early part (second section) of the discharging section may mean 10 seconds from the start point in time of the discharging section (first section). The value of 10 seconds may be set to a different value considering the inspection accuracy. In addition, the current values of 60 A and 120 A may be changed to different values depending on variations in process design.

All four voltage measurement values shown in graph 500 may decrease during the second section. The internal resistance of cell #1 and cell #2 may be calculated based on the voltage decrease amount and the discharging current values 60 A and 120 A during the second section. For example, the internal resistance may be a value obtained by dividing the voltage decrease amount by the discharging current value. The internal resistance calculated in this way may be the first internal resistance calculated in the environment of the capacity measurement process, and the first internal resistance may be corrected to the second internal resistance of the battery shipment environment.

Referring to FIG. 6, a table 600 representing charging and discharging data for the four voltage measurement values shown in the graph 500 may be shown. The table 600 may represent a voltage decrease amount dOCV, discharging current values Current and C-rate, and a first internal resistance R. As shown, some differences may occur in values of the first internal resistance R in the case of 60 A (0.6 C) and 120 A (1.2 C). However, it can be confirmed that the difference is not large.

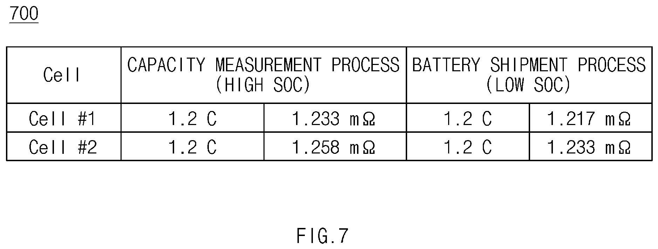

FIG. 7 illustrates a method of correcting the first internal resistance to the second internal resistance based on differences in battery environments according to some embodiments.

Referring to FIG. 7, a table 700 illustrating a method of correcting the first internal resistance to the second internal resistance based on the difference in the battery environment may be illustrated. The table 700 may compare a relatively high SOC in the capacity measurement process and a relatively low SOC in the battery shipment environment.

Since the capacity measurement process is performed in a section close to the full charging state of the target battery 110, the first internal resistance may be calculated in a relatively high SOC range. On the other hand, the shipment of the finished battery product may be performed in a shipment SOC range of approximately 30% to 80%.

The difference in internal resistance according to such SOC difference can be confirmed in the table 700. A table, profile, etc. that summarizes fluctuations of the internal resistance fluctuations according to the fluctuations of the SOC may be constructed in advance, and the first internal resistance may be corrected to the second internal resistance using the table, profile, etc. Meanwhile, in a similar manner to the SOC difference, the battery the difference in battery temperature may also cause a difference in internal resistance, and the internal resistance may be additionally corrected based on the temperature difference between the capacity measurement environment and the battery shipment environment.

With reference to FIGS. 5 to 7, the graph 500 may indicate a similarity of an initial resistance of 10 seconds with respect to a current of 120 A used in an internal resistance measurement section and a current of 60 A used in the capacity measurement section, based on the point in time (the same SOC) of the shipment charging process. The current of 60 A in the capacity measurement section may be set to a different value depending on the design change of the development model. The table 600 may represent resistance values calculated for 120 A of the internal resistance measurement section and 60 A of the capacity measurement section, and the table 700 may compare a measured resistance values by utilizing a portion of the section (top of SOC) at the start point in time of the capacity measurement and a resistance values measured for the same 120 A current in the internal resistance section.

In summary, as a result of resistance measurement according to different current values at the same SOC, it can be confirmed that the resistance values are similar to each other (ΔV also increases as the current increases), that a deviation of a resistance value according to a current magnitude is small in a battery cell of a predetermined capacity (e.g., 50 Ah) or more, and that a resistance value at different points in time (different SOCs) may be known by correcting the resistance value based on a discharge start point in time for capacity inspection.

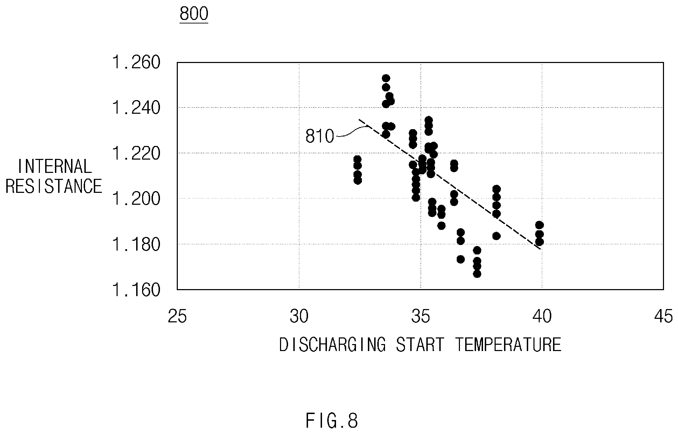

FIG. 8 illustrates a method of correcting an internal resistance of a battery based on a relationship between temperature and resistance according to some embodiments.

Referring to FIG. 8, a graph 800 illustrating the method of correcting the internal resistance of the battery based on the relationship between temperature and resistance may be illustrated. The horizontal axis of the graph 800 may represent the battery temperature at the point in time when discharging in the capacity measurement process starts, and the vertical axis may represent the internal resistance of the battery calculated based on the discharging current value and the voltage decrease amount.

As shown in a trend line 810, the higher the discharging start temperature, the lower the internal resistance. Since the discharging start temperature may be different for each battery, it may be necessary to correct the temperature effect in order to compare the internal resistances based on the same temperature. For example, in a quality assurance (QA) stage, a criterion temperature for the internal resistance inspection may be 25°C, and the internal resistance values at different discharging start temperatures may be corrected to the internal resistance value at 25°C.

$$\text{Equation 1: } R_{revised} = \{R_{discharge} + \alpha * (25°C - T)\} * \beta$$

As in Equation 1, the temperature effect on the internal resistance $R_{discharge}$ before correction, which is calculated based on the temperature at the start point in time of discharging, may be corrected by multiplying the difference between 25°C and the battery temperature T by the temperature correction factor $\alpha$. For example, the temperature correction factor $\alpha$ may be associated with a slope of the trend line 810. After correcting the temperature effect, the SOC correction factor $\beta$ may be additionally applied to calculate the internal resistance $R_{revised}$ after correction. $\alpha$ and $\beta$ maybe constants and may be determined by experiments.

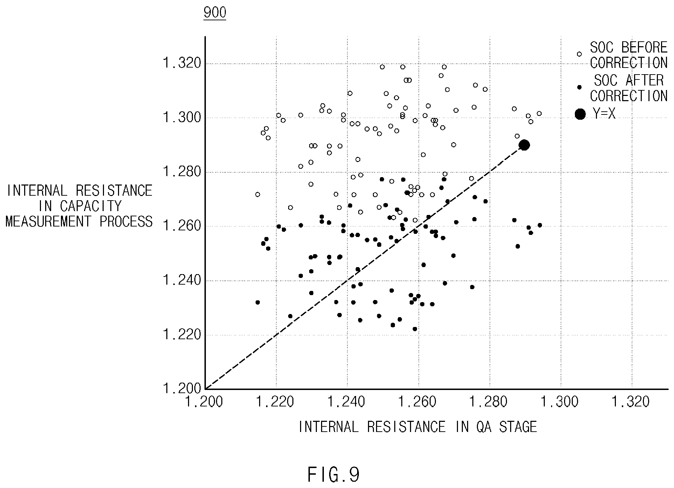

FIG. 9 illustrates a method of correcting an internal resistance of a battery based on a difference in battery SOC according to some embodiments.

Referring to FIG. 9, a graph 900 illustrating the method of correcting the internal resistance of the battery based on the difference in battery SOC may be illustrated. The horizontal axis of the graph 900 may represent internal resistance measured in a quality assurance (QA) stage, and the vertical axis may represent internal resistance measured in a capacity measurement process divided into before SOC correction and after SOC correction.

When the battery manufacturing is completed, the quality assurance (QA) stage may be performed on some of the finished batteries to be sampled. Various items including internal resistance may be inspected in the QA stage. The battery inspection system 120 may calculate the internal resistance based on the discharging current value and voltage decrease amount in the early part 410 of the discharging section of the capacity measurement process, and may correct this value to be the same as the internal resistance measured in the QA stage.

Since the temperature and SOC of the battery may be different in the early part 410 of the discharging section of the capacity measurement process and the QA stage, a correction for temperature and a correction for SOC may be performed. In the case of the temperature difference, the internal resistance measured at a temperature other than 25°C may be corrected to a value corresponding to 25°C. In the case of the SOC difference, in the early part 410 of the discharging section of the capacity measurement process, the SOC may be close to 100% due to full charging, whereas in the QA stage, the SOC may be a value according to the shipment condition (e.g., less than 30%). As in the table 700 of FIG. 7, since the internal resistance at 100% and the internal resistance at less than 30% are different, correction for this difference may be required.

The internal resistance values before SOC correction in the graph 900 may be values before the SOC correction coefficient β is applied after the temperature correction is applied in Equation 1. On the other hand, the internal resistance values after SOC correction of the graph 900 may represent the values after the SOC correction coefficient β is applied.

In the graph 900, the distribution of internal resistance values before SOC correction and the y = x graph have a difference, whereas after SOC correction, the distribution of internal resistance values may become closer to the y = x graph. That is, before SOC correction, the internal resistance estimated in the capacity measurement process may be different from the internal resistance precisely inspected in the QA stage, but after SOC correction, the internal resistance estimated in the capacity measurement process may be the same as or similar to the internal resistance precisely inspected in the QA stage.

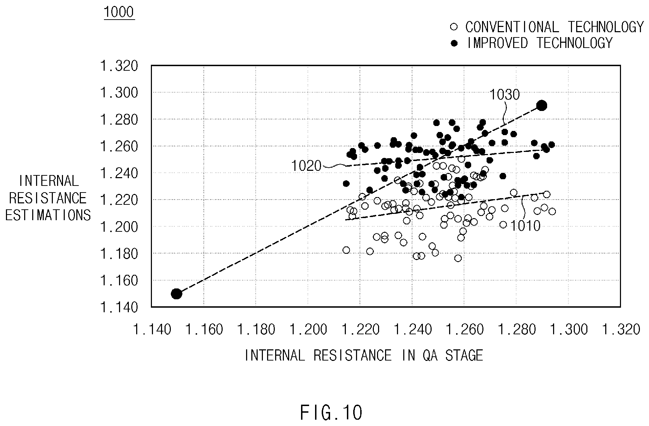

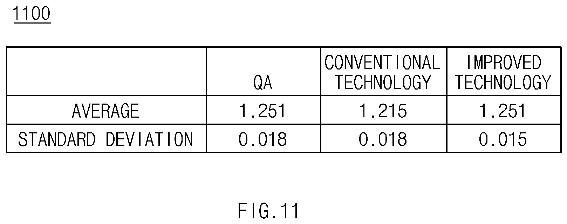

FIG. 10 and FIG. 11 illustrate differences between the battery inspection system according to some embodiments and a conventional inspection method.

Referring to FIG. 10, a graph 1000 showing a difference in performance between an improved technology according to the battery inspection system and a conventional technology may be illustrated. The conventional technology shown in the graph 1000 may correspond to the conventional technology discussed in FIG. 3.

In the graph 1000, the conventional technology may follow a first trend line 1010, and the improved technology may follow a second trend line 1020. In the conventional technology, since the capacity measurement and the internal resistance measurement are separated, a deviation of the internal resistance values may be relatively large due to a temperature deviation during a transfer process. In addition, since the first trend line 1010 of the conventional technology deviates from the y = x graph 1030, it can be confirmed that internal resistance estimation values according to the conventional technology are somewhat different from the internal resistance precisely inspected in the QA stage. On the other hand, in the second trend line 1020 according to the improved technology, since the temperature correction and SOC correction are performed, even if the internal resistance is measured together in the capacity measurement process without a separate process, the internal resistance estimation values may be the same as or similar to the internal resistance precisely inspected in the QA stage.

Referring to FIG. 11, a table 1100 illustrating a difference between the battery inspection system and a conventional inspection method may be illustrated.

In the QA stage, an average of internal resistances may be 1.251 Ω, and the standard deviation thereof may be 0.018. In the case of the conventional technology discussed in FIG. 3, there is no difference in SOC compared to the QA stage, but since a temperature difference may occur, the average may be 1.215 Ω, which may be significantly different from 1.251 Ω in the QA stage. Such an average difference may be shown as a difference between the first trend line 1010 and the y = x graph 1030 in the graph 1000.

On the other hand, in the improved technology according to the battery inspection system 120, since the internal resistance is measured in the early part 410 of the discharging section of the capacity measurement process as in FIG. 4, a temperature difference and SOC difference may exist. However, since correction for temperature difference and correction for SOC difference are performed, the average of internal resistances may be the same as the average in the QA stage, as illustrated in FIG. 8.

In addition, in the conventional technology, the temperature deviation may increase due to the transfer time, etc. in the process of performing separate charging and discharging 310 for measuring internal resistance, but in the case of the improved technology, since the battery inspection system 120 performs internal resistance measurement simultaneously with capacity measurement, additional transfer may be unnecessary, the temperature deviation may be reduced, and thus the standard deviation of internal resistance values may be reduced.

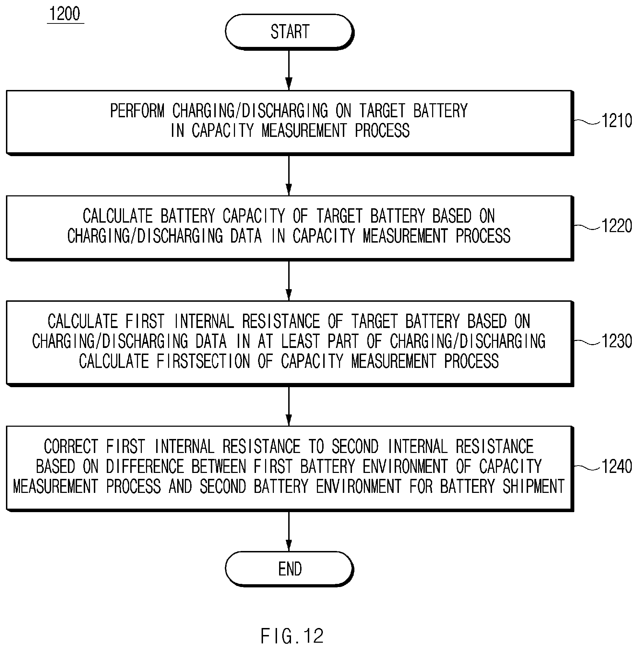

FIG. 12 illustrates steps that constitute a battery inspection method according to some embodiments.

Referring to FIG. 12, a battery inspection method 1200 may include steps 1210 to 1240. However, it is not limited thereto, and some steps may be omitted or other general steps may be added, and the steps of the battery inspection method 1200 may be executed in a different order from the illustrated order.

The battery inspection method 1200 may be composed of steps that are processed in time series in the battery inspection system 120. Therefore, even if the content is omitted below, the content described above for the battery inspection system 120 may be equally applied to the battery inspection method 1200.

Steps 1210 to 1240 of the battery inspection method 1200 may be performed by the transfer device 121, the control device 122, and the charging/discharging device 123 of the battery inspection system 120.

In step 1210, the battery inspection system 120 may perform performing charging/discharging on a target battery in a capacity measurement process.

In step 1220, the battery inspection system 120 may perform calculating a battery capacity of the target battery based on charging/discharging data in the capacity measurement process.

In step 1230, the battery inspection system 120 may perform calculating a first internal resistance of the target battery based on the charging/discharging data in at least a partial section of the charging/discharging section of the capacity measurement process.

In step 1240, the battery inspection system 120 may perform correcting the first internal resistance to a second internal resistance based on a difference between a first battery environment of the capacity measurement process and a second battery environment for battery shipment.

According to the embodiment, the battery inspection method 1200 may be implemented in the form of a computer program stored in a computer-readable storage medium. That is, the computer program may include instructions for implementing the battery inspection method 1200, and the instructions of the program may be stored in the computer-readable storage medium. The computer program may include a mobile application.

According to the embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, and the like. The computer program instructions may include machine language code generated by a compiler and high-level language code that can be executed by a computer using an interpreter, etc.

The terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and those skilled in the art to which the embodiments disclosed in this document belong may make various modifications and variations thereto without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted in accordance with the scope of the claims below, and all technical ideas within the equivalent scope should be interpreted as being included in the scope of rights of this document.

[Description of Symbols]

110: Target battery 120: Battery inspection system
121: Transfer device 122: Control device
123: Charging/discharging device

**Claims**

**1.** A battery inspection device, comprising:

a charging/discharging device configured to perform charging/discharging on a target battery in a capacity measurement process; and
a control device configured to:

calculate a battery capacity of the target battery based on charging/discharging data in the capacity measurement process;

calculate a first internal resistance of the target battery based on the charging/discharging data in at least a partial section of a charging/discharging section of the capacity measurement process; and

correct the first internal resistance to a second internal resistance based on a difference between a first battery environment in the capacity measurement process and a second battery environment for battery shipment.

2. The battery inspection device of claim 1, wherein the charging/discharging device is configured to partially charge the target battery according to a shipping condition in a shipment charging process when the charging/discharging section of the capacity measurement process is completed.

3. The battery inspection device of claim 2, wherein the battery inspection system further includes a transfer device configured to transfer the target battery from the shipment charging process to an end of line (EOL) process when the partial charging of the target battery is completed in the shipment charging process, and

the second battery environment represents an environment in which an internal resistance measurement process does not exist between the shipment charging process and the EOL process.

4. The battery inspection device of claim 3, wherein the charging/discharging section of the capacity measurement process includes a first section for discharging the target battery from a full charging state to a full discharging state, and

the control device is configured to calculate the first internal resistance based on the charging/discharging data in a second section of at least a part of the first section.

5. The battery inspection device of claim 4, wherein a start point in time of the first section coincides with a start point in time of the second section, and

the control device is configured to calculate the first internal resistance based on a discharging current value in the first section set for measuring the battery capacity in the capacity measurement process and a voltage decrease amount of the target battery during the second section.

6. The battery inspection device of claim 5, wherein the difference between the first battery environment and the second battery environment includes a difference between a first SOC value corresponding to a full charging state of the second section and a second SOC value corresponding to a partial charging state for the battery shipment, and

the control device is configured to correct the first internal resistance to the second internal resistance based on the difference between the first SOC value and the second SOC value.

7. The battery inspection device of claim 6, wherein the difference between the first battery environment and the second battery environment includes a difference between a first battery temperature in the capacity measurement process and a second battery temperature in the shipment charging process, and

the control device is configured to correct the first internal resistance to the second internal resistance based on the difference between the first battery temperature and the second battery temperature.

8. A battery inspection method, comprising:

performing charging/discharging on a target battery in a capacity measurement process;
calculating a battery capacity of the target battery based on charging/discharging data in the capacity measurement process;
calculating a first internal resistance of the target battery based on the charging/discharging data in at least a partial section of a charging/discharging section of the capacity measurement process; and
correcting the first internal resistance to a second internal resistance based on a difference between a first battery environment in the capacity measurement process and a second battery environment for battery shipment.

9. The battery inspection method of claim 8, further comprising:
partially charging the target battery according to a shipping condition in a shipment charging process when the charging/discharging section of the capacity measurement process is completed.

10. The battery inspection method of claim 9, further comprising:

transferring the target battery from the shipment charging process to an end of line (EOL) process when the partial charging of the target battery is completed in the shipment charging process,

wherein the second battery environment represents an environment in which an internal resistance measurement process does not exist between the shipment charging process and the EOL process.

11. The battery inspection method of claim 10, wherein the charging/discharging section of the capacity measurement process includes a first section for discharging the target battery from a full charging state to a full discharging state, and

the calculating of the first internal resistance includes calculating the first internal resistance based on the charging/discharging data in a second section of at least a part of the first section.

12. The battery inspection method of claim 11, wherein a start point in time of the first section coincides with a start point in time of the second section, and

the calculating of the first internal resistance includes calculating the first internal resistance based on a discharging current value in the first section set for measuring the battery capacity in the capacity measurement process and a voltage decrease amount of the target battery during the second section.

13. The battery inspection method of claim 12, wherein the difference between the first battery environment and the second battery environment includes a difference between a first SOC value corresponding to a full charging state of the second section and a second SOC value corresponding to a partial charging state for the battery shipment, and

the correcting of the first internal resistance to the second internal resistance includes correcting the first internal resistance to the second internal resistance based on the difference between the first SOC value and the second SOC value.

14. The battery inspection method of claim 13, wherein the difference between the first battery environment and the second battery environment includes a difference between a first battery temperature in the capacity measurement process and a second battery temperature in the shipment charging process, and

the correcting of the first internal resistance to the second internal resistance includes correcting the first internal resistance to the second internal resistance based on the difference between the first battery temperature and the second battery temperature.

TARGET BATTERY 110 ⟷ BATTERY INSPECTION SYSTEM 120

FIG.1

BATTERY INSPECTION SYSTEM
120

TRANSFER DEVICE
121

CONTROL DEVICE
122

CHARGING/DISCHARGING DEVICE
123

FIG.2

FIG.3

400

voltage

410

CAPACITY
MEASUREMENT
PROCESS

SHIPMENT
CHARGING
PROCESS

EOL PROCESS

time

DISCHARGE
SECTION

FIG.4

FIG.5

600

| Cell | dOCV | Current | C-rate | R |
|------|------|---------|--------|---|
| Cell #1 | 76 mV | 60.0 A | 0.6 C | 1.266 mΩ |
| | 148 mv | 120.0 A | 1.2 C | 1.233 mΩ |
| Cell #2 | 77 mV | 60.0 A | 0.6 C | 1.283 mΩ |
| | 151 mv | 120.0 A | 1.2 C | 1.258 mΩ |

FIG.6

700

| Cell | CAPACITY MEASUREMENT PROCESS (HIGH SOC) | | BATTERY SHIPMENT PROCESS (LOW SOC) | |
|---|---|---|---|---|
| Cell #1 | 1.2 C | 1.233 mΩ | 1.2 C | 1.217 mΩ |
| Cell #2 | 1.2 C | 1.258 mΩ | 1.2 C | 1.233 mΩ |

FIG.7

FIG.8

900

FIG.9

FIG.10

1100

| | QA | CONVENTIONAL TECHNOLOGY | IMPROVED TECHNOLOGY |
|---|---|---|---|
| AVERAGE | 1.251 | 1.215 | 1.251 |
| STANDARD DEVIATION | 0.018 | 0.018 | 0.015 |

FIG.11

1200

```
                    ┌─────────────┐
                    │    START    │
                    └─────────────┘
                           │
                           ▼
┌──────────────────────────────────────────────────────┐
│     PERFORM CHARGING/DISCHARGING ON TARGET BATTERY     │  ～1210
│           IN CAPACITY MEASUREMENT PROCESS              │
└──────────────────────────────────────────────────────┘
                           │
                           ▼
┌──────────────────────────────────────────────────────┐
│     CALCULATE BATTERY CAPACITY OF TARGET BATTERY BASED ON│  ～1220
│   CHARGING/DISCHARGING DATA IN CAPACITY MEASUREMENT PROCESS│
└──────────────────────────────────────────────────────┘
                           │
                           ▼
┌──────────────────────────────────────────────────────┐
│    CALCULATE FIRST INTERNAL RESISTANCE OF TARGET BATTERY BASED ON│  ～1230
│  CHARGING/DISCHARGING DATA IN AT LEAST PART OF CHARGING/DISCHARGING│
│      CALCULATE FIRSTSECTION OF CAPACITY MEASUREMENT PROCESS│
└──────────────────────────────────────────────────────┘
                           │
                           ▼
┌──────────────────────────────────────────────────────┐
│     CORRECT FIRST INTERNAL RESISTANCE TO SECOND INTERNAL RESISTANCE│  ～1240
│    BASED ON DIFFERENCE BETWEEN FIRST BATTERY ENVIRONMENT OF CAPACITY│
│ MEASUREMENT PROCESS AND SECOND BATTERY ENVIRONMENT FOR BATTERY SHIPMENT│
└──────────────────────────────────────────────────────┘
                           │
                           ▼
                    ┌─────────────┐
                    │     END     │
                    └─────────────┘
```

FIG.12

## INTERNATIONAL SEARCH REPORT

| International application No. |
|---|
| **PCT/KR2025/007346** |

### A. CLASSIFICATION OF SUBJECT MATTER

**G01R 31/385**(2019.01)i; **G01R 31/389**(2019.01)i; **G01R 31/396**(2019.01)i; **G01R 31/371**(2019.01)i; **G01R 31/374**(2019.01)i; **G01R 31/367**(2019.01)i; **G01R 27/08**(2006.01)i; **H02J 7/00**(2006.01)i

According to International Patent Classification (IPC) or to both national classification and IPC

### B. FIELDS SEARCHED

Minimum documentation searched (classification system followed by classification symbols)

G01R 31/385(2019.01); G01R 19/00(2006.01); G01R 31/36(2006.01); G01R 31/367(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 검사(inspection), 충전(charge), 내부 저항(internal resistance), 보정(correction)

### C. DOCUMENTS CONSIDERED TO BE RELEVANT

| Category* | Citation of document, with indication, where appropriate, of the relevant passages | Relevant to claim No. |
|---|---|---|
| Y | KR 10-2023-0155097 A (WONIK PNE CO., LTD.) 10 November 2023 (2023-11-10)<br>paragraphs [0049]-[0094] and figures 1-5 | 1-14 |
| Y | KR 10-2014-0125473 A (SAMSUNG SDI CO., LTD.) 29 October 2014 (2014-10-29)<br>paragraph [0021], claim 15 and figures 1-4 | 1-14 |
| A | KR 10-2436468 B1 (SM ELECTRONIC CO., LTD.) 29 August 2022 (2022-08-29)<br>paragraphs [0023]-[0125] and figures 1-9 | 1-14 |
| A | KR 10-2022-0131703 A (KOREA ELECTRIC POWER CORPORATION) 29 September 2022 (2022-09-29)<br>paragraphs [0028]-[0067] and figures 1-6 | 1-14 |
| A | JP 2023-139911 A (FURUKAWA ELECTRIC CO., LTD. et al.) 04 October 2023 (2023-10-04)<br>paragraphs [0044]-[0156] and figures 1-11 | 1-14 |

☐ Further documents are listed in the continuation of Box C.   ☑ See patent family annex.

| | | |
|---|---|---|
| * | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 August 2025** | **29 August 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2025/007346**

| Patent document cited in search report | | | Publication date (day/month/year) | Patent family member(s) | | | Publication date (day/month/year) |
|---|---|---|---|---|---|---|---|
| KR | 10-2023-0155097 | A | 10 November 2023 | KR | 10-2704741 | B1 | 09 September 2024 |
| KR | 10-2014-0125473 | A | 29 October 2014 | CN | 104113103 | A | 22 October 2014 |
| | | | | CN | 104113103 | B | 28 May 2019 |
| | | | | EP | 2793038 | A2 | 22 October 2014 |
| | | | | EP | 2793038 | A3 | 31 December 2014 |
| | | | | EP | 2793038 | B1 | 06 May 2020 |
| | | | | EP | 2952922 | A1 | 09 December 2015 |
| | | | | EP | 2952922 | B1 | 10 July 2019 |
| | | | | JP | 2014-211427 | A | 13 November 2014 |
| | | | | JP | 6622448 | B2 | 18 December 2019 |
| | | | | KR | 10-2082866 | B1 | 14 April 2020 |
| | | | | US | 2014-0312910 | A1 | 23 October 2014 |
| KR | 10-2436468 | B1 | 29 August 2022 | None | | | |
| KR | 10-2022-0131703 | A | 29 September 2022 | KR | 10-2554505 | B1 | 13 July 2023 |
| JP | 2023-139911 | A | 04 October 2023 | None | | | |

Form PCT/ISA/210 (patent family annex) (July 2022)

**EP 4 768 952 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240086062